(19) Europäisches Patentamt
European Patent Office
Office européen des brevets

(11)  **EP 4 325 231 B1**

(12)  **EUROPEAN PATENT SPECIFICATION**

(45) Date of publication and mention
of the grant of the patent:
**18.06.2025   Bulletin 2025/25**

(21) Application number: **22890404.1**

(22) Date of filing: **03.11.2022**

(51) International Patent Classification (IPC):
*G01R 31/367* (2019.01)    *G01R 31/396* (2019.01)
*G01R 31/392* (2019.01)    *G01R 31/389* (2019.01)
*G01R 31/3835* (2019.01)

(52) Cooperative Patent Classification (CPC):
**G01R 31/389; G01R 31/367; G01R 31/3835;
G01R 31/392; G01R 31/396**

(86) International application number:
**PCT/KR2022/017127**

(87) International publication number:
**WO 2023/080673 (11.05.2023 Gazette 2023/19)**

(54)  **DEVICE, METHOD AND SYSTEM FOR ESTIMATING IMPEDANCE SPECTRUM OF BATTERY**

VORRICHTUNG, VERFAHREN UND SYSTEM ZUR SCHÄTZUNG DES IMPEDANZSPEKTRUMS EINER BATTERIE

DISPOSITIF, PROCÉDÉ ET SYSTÈME D'ESTIMATION DE SPECTRE D'IMPÉDANCE D'UNE BATTERIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **03.11.2021   KR 20210149820**

(43) Date of publication of application:
**21.02.2024   Bulletin 2024/08**

(73) Proprietor: **LG Energy Solution, Ltd.
Seoul 07335 (KR)**

(72) Inventors:
• **KIM, Younghwan
Daejeon 34122 (KR)**
• **KIM, Jeong Wan
Daejeon 34122 (KR)**

(74) Representative: **Plasseraud IP
104 Rue de Richelieu
CS92104
75080 Paris Cedex 02 (FR)**

(56) References cited:
EP-A1- 3 876 334          WO-A1-2021/170866
KR-A- 20200 117 794    KR-B1- 101 759 532
KR-B1- 102 280 292      KR-B1- 102 280 292
US-A1- 2020 386 820

**Description**

[Technical Field]

This application claims priority to and the benefit of Korean Patent Application No. 10-2021-0149820 filed in the Korean Intellectual Property Office on November 3, 2021 and Korean Patent Application No. 10-2022-0145075 filed in the Korean Intellectual Property Office on November 3, 2022.

The present invention relates to a device and a method for estimating an impedance spectrum of a battery, and a system including the same, and more particularly, to a device and a method for estimating an impedance spectrum of a battery, and a system including the same, which estimate a cell-unit battery impedance spectrum value from a pack or module-unit battery impedance spectrum measurement value.

[Background Art]

In the case of batteries that are operated or reused, it is most important to diagnose a state.

In general, in order to diagnose the state of the battery, a charging state (SOC) and a lifespan state (SOH) of the battery are checked.

In order to check the charging state (SOC) and a lifespan state (SOH) of the battery, an impedance spectrum of a battery cell is measured by electrical impedance spectroscopy (hereinafter, referred to as EIS) in the related art.

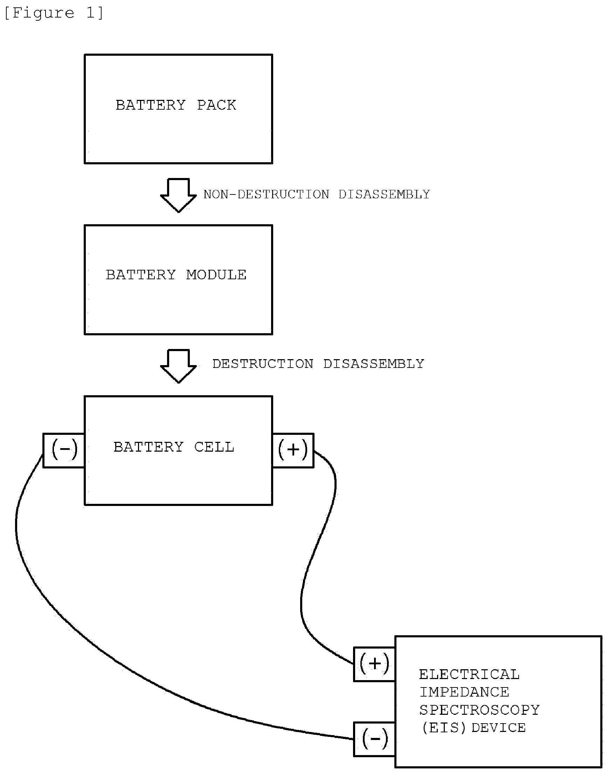

In the measurement of the impedance spectrum of the battery cell using the EIS device in the related art, a battery provided in the form of a pack or a module is disassembled in units of a cell, and the impedance spectrum is measured by connecting an EIS measurement device to anode (+) and cathode (-) leads of the respective decomposed cells, as illustrated in FIG. 1.

In general, when disassembling the battery pack to a module unit, it is possible to disassemble nondestructive disassembling by removing and disassembling a bus bar used for connection between the battery modules. However, when disassembling the cell unit in the battery module, the battery module should be disassembled by destructing a welded portion of the cell lead using a laser or ultrasonic, so it is difficult to reassemble the cells to the battery module unless the cell lead is replaced, and the battery cells should be reassembled by disassembling the battery cell in units of parts in order to replace the cell lead.

EP 3 876 334 A1 provides a battery management apparatus and method, to construct a battery model optimized for a battery cell by obtaining a parameter of the battery model through a neural network and then repeatedly updating the parameter of the battery model based on a difference between an output value of the battery model that reflects the obtained parameter and an actually measured value, and control charging of the battery based on the optimized battery model.

[Disclosure]

[Technical Problem]

In order to solve the problem, an object of the present invention is to provide a device for estimating an impedance spectrum of a high-efficiency and low-cost battery, which estimates a cell-unit battery impedance spectrum value from an impedance spectrum measurement value of a pack or module-unit battery assembly.

In order to solve the problem, another object of the present invention is to provide a method for estimating an impedance spectrum of a high-efficiency and low-cost battery, which estimates a cell-unit battery impedance spectrum value from an impedance spectrum measurement value of a pack or module-unit battery assembly.

In order to solve the problem, yet another object of the present invention is to provide a system for estimating an impedance spectrum of a high-efficiency and low-cost battery, which estimates a cell-unit battery impedance spectrum value from an impedance spectrum measurement value of a pack or module-unit battery assembly.

[Technical Solution]

In order to achieve the object, a device for estimating an impedance spectrum of a battery cell according to the present invention includes: a memory; and a processor performing at least one command stored in the memory, in which the at least one command includes a command of instructing acquiring an electrical impedance spectroscopy (EIS) measurement value of a battery assembly, a command of instructing modeling an equivalent circuit model (ECM) of the battery assembly, and determining initial parameter values for the equivalent circuit, based on the EIS measurement value, a command of instructing deriving a first parameter value by converting at least one of the initial parameter values by using a predefined conversion constant, and calculating a first cell voltage value based on the first parameter value, a command of instructing acquiring a second cell voltage value measured by charging or discharging the battery cell, a command of instructing comparing the first cell voltage value and the second cell voltage value, and correcting the conversion constant based on a comparison result, a command of instructing calculating a final parameter value based on the corrected conversion constant, and a command of instructing acquiring an EIS estimation value for the battery cell by applying the final parameter value to the equivalent circuit.

Here, the initial parameter value of the equivalent circuit may include a parameter value of at least one of a resistance, a capacitor, an inductor, and a constant phase element (CPE).

Further, the conversion constant may be a constant for converting the equivalent circuit of the battery assembly into the equivalent circuit of the battery cell.

Meanwhile, the command of instructing calculating the first cell voltage value may include a command of instructing converting the equivalent circuit into an impedance function for a time, and acquiring an internal impedance by applying the initial parameter value to the impedance function, and a command of instructing calculating the first cell voltage value by multiplying the internal impedance by a current value.

In this case, the impedance function may be a function of converting the equivalent circuit into a function for the time by using a predefined differential equation.

Meanwhile, the second cell voltage value may be a cell voltage value measured by discharge pulse current of the battery cell.

Further, the command of instructing correcting the conversion constant may include a command of instructing correcting the conversion constant so that a difference between the first cell voltage value and the second cell voltage value is minimized.

In order to achieve the object, a method for estimating an impedance spectrum of a battery cell according to the present invention includes: acquiring an electrical impedance spectroscopy (EIS) measurement value of a battery assembly; modeling an equivalent circuit model (ECM) of the battery assembly, and determining initial parameter values for the equivalent circuit, based on the EIS measurement value; deriving a first parameter value by converting at least one of the initial parameter values by using a predefined conversion constant, and calculating a first cell voltage value based on the first parameter value; acquiring a second cell voltage value measured by charging or discharging for the battery cell; comparing the first cell voltage value and the second cell voltage value, and correcting the conversion constant based on a comparison result; calculating a final parameter value based on the corrected conversion constant; and acquiring an EIS estimation value for the battery cell by applying the final parameter value to the equivalent circuit.

Here, at least one initial parameter value of the equivalent circuit may include a parameter value of at least one of a resistance, a capacitor, an inductor, and a constant phase element (CPE).

Further, the conversion constant may be a constant for converting the equivalent circuit of the battery assembly into the equivalent circuit of the battery cell.

Meanwhile, the calculating of the first cell voltage value may include converting the equivalent circuit into an impedance function for a time, and acquiring an internal impedance by applying the initial parameter value to the impedance function, and calculating the first cell voltage value by multiplying the internal impedance by a current value.

In this case, the impedance function may be a function of converting the equivalent circuit into a function for the time by using a predefined differential equation.

Meanwhile, the second cell voltage value may be a cell voltage value measured by discharge pulse current of the battery cell.

Further, the correcting of the conversion constant may include correcting the conversion constant so that a difference between the first cell voltage value and the second cell voltage value is minimized.

In order to achieve the object a system for estimating an impedance spectrum of the battery cell according to the present invention includes: an electrical impedance spectroscopy (EIS) device measuring an impedance spectrum value of a battery assembly; an impedance estimation device of the battery cell calculating a first cell voltage for a battery cell, and acquiring an EIS estimation value of the battery cell; and a battery charging/discharging measurement device measuring a second cell voltage by charging or discharging for the battery cell, in which the impedance estimation device of the battery cell models an equivalent circuit model (ECM) of the battery assembly, and determines at least one of initial parameter values for the equivalent circuit, based on the EIS device measurement value, derives a first parameter value by converting at least one of the initial parameter values by using a predefined conversion constant, and calculates a first cell voltage value based on the first parameter value, corrects the conversion constant by comparing the calculated first cell voltage value, and the second cell voltage value measured by the battery charging/discharging measurement device, calculates a final parameter value based on the corrected conversion constant, and acquires the EIS estimation value for the battery cell by applying the final parameter value to the equivalent circuit.

[Advantageous Effects]

According to an embodiment and an experimental example of the present invention, a device and a method for estimating an impedance spectrum of a battery, and a system including the same can provide a device and a method for estimating an impedance spectrum of a high-efficiency and low-cost battery, and a system including the same, which estimate a cell-unit battery impedance spectrum value by acquiring measurement values from an Electrical Impedance Spectroscopy (EIS) device measuring an impedance spectrum value of a pack or module-unit battery assembly and a battery charging/discharging measurement device measuring a specific parameter value by charging or discharging by applying pulse current to the pack or module-unit battery assembly to facilitate reassembly and reduce cost by enabling non-destruction measurement without disassembling the battery into the cell unit.

[Description of Drawings]

FIG. 1 illustrates an image of an electrical impedance spectroscopy (EIS) device connected to a battery cell in the related art.

FIG. 2 is a block diagram of a system for estimating an impedance spectrum of a battery cell according to an embodiment of the present invention.

FIG. 3 illustrates an image of an electrical impedance spectroscopy (EIS) device according to an embodiment of the present invention.

FIG. 4 illustrates an image of a battery charging/discharging measurement device according to an embodiment of the present invention.

FIG. 5 is a block diagram of a device for estimating an impedance spectrum according to an embodiment of the present invention.

FIG. 6 is a flowchart for describing a method for measuring an impedance spectrum of a battery cell according to an embodiment of the present invention.

FIG. 7 is a Nyquist Plot graph showing an impedance measurement result for each frequency of a pack or module-unit battery assembly using an electrical impedance spectroscopy (EIS) device according to an embodiment of the present invention.

FIG. 8 is an equivalent circuit diagram of a battery assembly acquired based on the impedance measurement result in FIG. 7.

FIG. 9 is a graph of comparing a first cell voltage value calculated by using an impedance function to which a first parameter is applied and a second cell voltage value measured by applying discharge pulse current to a battery assembly in order to describe a method for estimating an impedance of a battery cell according to an experimental example of the present invention.

FIG. 10 is a graph of comparing a third cell voltage value calculated by using an equivalent circuit model to which a final parameter value is applied and a second cell voltage value measured by applying discharge pulse current to a battery assembly in order to describe a method for estimating an impedance of a battery cell according to an experimental example of the present invention.

1000: Electrical impedance spectroscopy (EIS) device
3000: Battery charging/discharging measurement device
5000: Impedance spectrum estimation device of battery cell
S: Impedance spectrum estimation system of battery cell
100: Memory
200: Processor
300: Transceiving device
400: Input interface device
500: Output interface device
600: Storage device
700: Bus

[Best Mode for the Invention]

various modifications and various embodiments and specific embodiments will be illustrated in the drawings and described in detail in the detailed description. However, this does not limit the present invention which is defined by the appended claims. In describing each drawing, reference numerals refer to like elements.

Terms including as first, second, A, B, and the like are used for describing various constituent elements, but the constituent elements are not limited by the terms. The terms are used only to discriminate one element from another element. A term 'and/or' includes a combination of a plurality of associated disclosed items or any item of the plurality of associated disclosed items.

It should be understood that, when it is described that a component is "connected to" or "accesses" another component, the component may be directly connected to or access the other component or a third component may be present therebetween. In contrast, when it is described that a component is "directly connected to" or "directly accesses" another component, it is understood that no element is present between the element and another element.

A singular form includes a plural form if there is no clearly opposite meaning in the context. In the present application, it should be understood that the term "include" or "have"indicates that a feature, a number, a step, an operation, a component, a part or the combination thereof described in the specification is present, but does not exclude a possibility of presence or addition of one or more other features, numbers, steps, operations, components, parts or combinations thereof, in advance.

If not contrarily defined, all terms used herein including technological or scientific terms have the same meanings as those generally understood by a person with ordinary skill in the art. Terms which are defined in a generally used dictionary should be interpreted to have the same meaning as the meaning in the context of the related art, and are not interpreted as an ideal meaning or excessively formal meanings unless clearly defined in the present application.

Hereinafter, a preferred embodiment of the present invention will be described in detail with reference to the accompanying drawings.

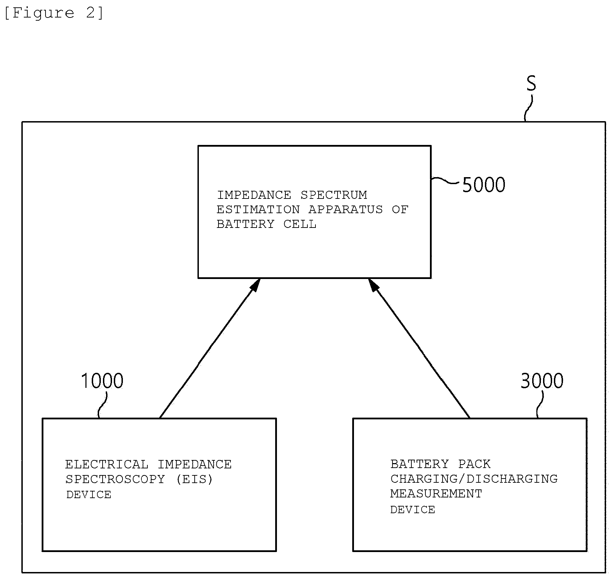

FIG. 2 is a block diagram of a system for estimating an impedance spectrum of a battery cell according to an embodiment of the present invention.

Referring to FIG. 2, a system S for estimating an impedance spectrum of a battery cell according to an embodiment of the present invention measures charging or discharging data depending on application of an impedance spectrum and pulse current to a battery assembly to estimate a battery cell-unit impedance spectrum value. Here, the battery assembly may include a battery provided in the form of a pack or a module.

According to the embodiment, more specifically, the system S for estimating an impedance spectrum of a battery cell may include an electrical impedance spectroscopy (EIS) device 1000, a charging/discharging measurement device 3000, and an impedance spectrum estimation device 5000.

In this case, the electrical impedance spectroscopy (EIS) device 1000 may measure an impedance for the battery assembly, the charging/discharging measurement device 3000 may measure cell voltage of the battery for the battery assembly, and the impedance spectrum estimation device 5000 may estimate the battery cell-unit impedance spectrum value based on the measurement values measured from the electrical impedance spectroscopy (EIS) device 1000 and the charging/discharging measurement device 3000.

Hereinafter, a feature for each component of the system S for estimating an impedance spectrum of a battery cell will be described in more detail with reference to the drawing.

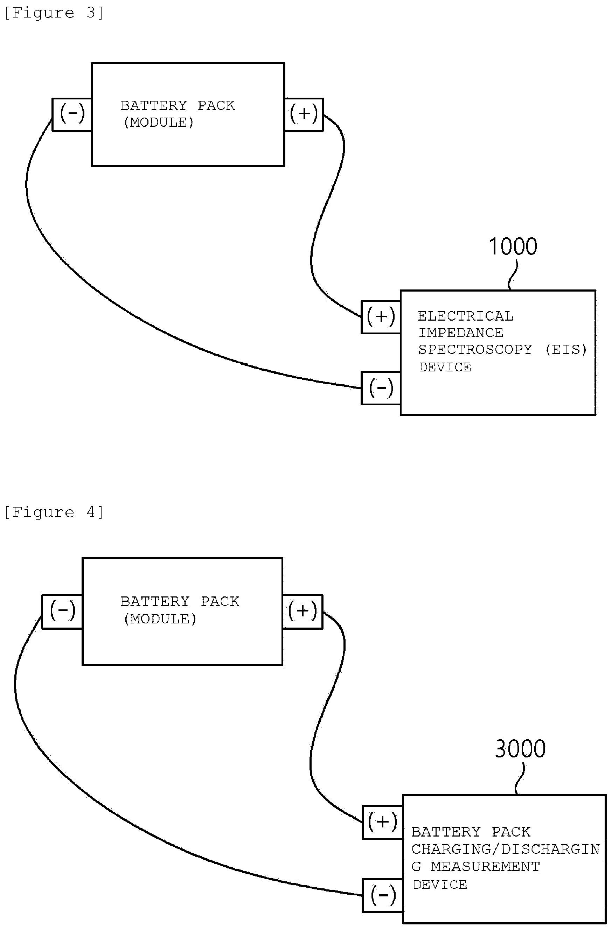

FIG. 3 illustrates an image of an electrical impedance spectroscopy (EIS) device according to an embodiment of the present invention.

Referring to FIG. 3, the electrical impedance spectroscopy (EIS) device 1000 is connected to a battery assembly provided in units of a pack or a module to measure the impedance spectrum of the battery assembly.

According to an embodiment, the electrical impedance spectroscopy (EIS) device 1000 is connected to the anode (+) and cathode (-) leads of the battery pack or module to measure the impedance spectrum of the battery pack or module.

Thereafter, the electrical impedance spectroscopy (EIS) device 1000 may transmit an impedance spectrum measurement value of the battery pack or module to the impedance spectrum estimation device 5000 to be described below.

The electrical impedance spectroscopy (EIS) device in the related art measures the impedance spectrum of the battery cell by connecting the battery assembly provided in units of the pack or module to battery cells disassembled in units of the cell, but should destruct a welding portion of a cell lead at the time of disassembling the battery into the cell unit to be disadvantageous in that reassembling after measurement is difficult.

However, the system S for estimating the impedance spectrum of the battery cell according to an embodiment of the present invention may provide a system S for estimating the impedance spectrum of the high-efficiency and low-cost battery cell, which measures the impedance spectrum of the pack or module-unit battery assembly using the electrical impedance spectroscopy (EIS) device 1000 and estimates the battery cell-unit impedance spectrum value by correcting the measured impedance spectrum to facilitate reassembly by non-destruction measurement, and reduce cost.

FIG. 4 illustrates an image of a battery charging/discharging measurement device according to an embodiment of the present invention.

Referring to FIG. 4, the battery charging/discharging measurement device 3000 may be connected to the battery assembly provided in the units of the pack or module.

Thereafter, the battery charging/discharging measurement device 3000 performs charging or discharging of the battery applying pulse current to the battery to measure the cell voltage of the battery.

According to an embodiment, the battery charging/discharging measurement device 3000 is connected to anode (+) and cathode (-) leads of the battery assembly and applies the pulse current to the pack or module-form battery assembly, thereby measuring the cell voltage depending on battery charging or discharging.

Thereafter, the battery charging/discharging measurement device 3000 may transmit a cell voltage measurement value depending on the battery charging or discharging to the impedance spectrum estimation device 5000 to be described below.

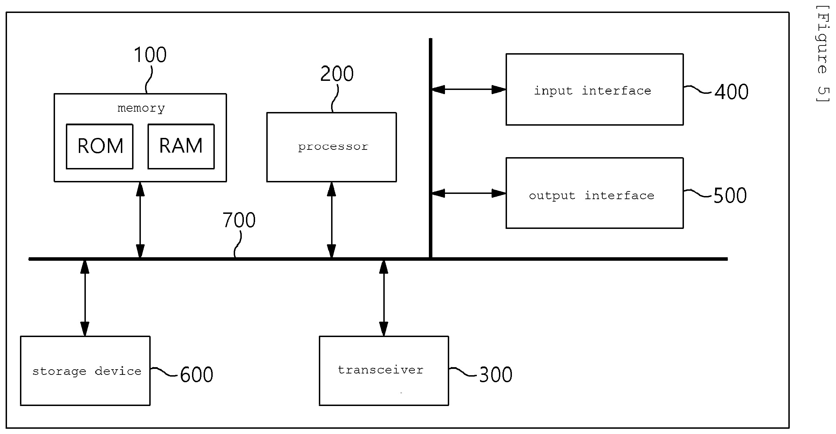

FIG. 5 is a block diagram of a device for estimating an impedance spectrum according to an embodiment of the present invention.

Referring to FIG. 5, the device 5000 for estimating the impedance spectrum according to an embodiment of the present invention receives the impedance spectrum measurement value and the cell voltage measurement value for the pack or module-form battery assembly measured by the electrical impedance spectroscopy (EIS) device 1000 and the battery charging/discharging measurement device 3000 to estimate the cell-unit battery impedance spectrum.

When the device 5000 for estimating an impedance spectrum of a battery cell is described in more detail for each hardware component, the impedance spectrum estimation device 5000 may include a memory 100, a processor 200, a transceiving device 300, an input interface device 400, an output interface device 500, and a storage device 600.

According to an embodiment, respective components 100, 200, 300, 400, 500, and 600 included in the impedance spectrum estimation device 5000 are connected to each other by a bus 700 to communicate with each other.

Among the components 100, 200, 300, 400, 500, and 600 of the impedance spectrum estimation device 5000, the memory 100 and the storage device 600 may be constituted by at least one of a volatile storage medium and a non-volatile storage medium. For example, the memory 100 and the storage device 600 may be constituted by at least one of a read only memory (ROM) and a random access memory (RAM).

Among them, the memory 100 may include at least one instruction executed by the processor 200.

According to an embodiment, at least one instruction may include a command of instructing acquiring an electrical impedance spectroscopy (EIS) measurement value of the battery assembly, a command of instructing modeling an equivalent circuit model (ECM) of the battery assembly based on the EIS measurement value, and determining initial parameter values for the equivalent circuit, a command of instructing deriving a first parameter value by converting at least one of the initial parameter values by using a predefined conversion constant, and calculating a first cell voltage value based on the first parameter value, a command of instructing acquiring a second cell voltage value measured by charging or discharging for the battery cell, a command of instructing comparing the first cell voltage value and the second cell voltage value, and correcting the conversion constant based on a comparison result, a command of instructing calculating a final parameter value based on the corrected conversion constant, and a command of instructing acquiring an EIS estimation value for the battery cell by applying the final parameter value to the equivalent circuit.

The processor 200 may mean a central processing unit (CPU), a graphics processing unit (GPU), or a dedicated processor that perform the methods according to embodiments of the present invention.

The processor 200 may execute at least one program command stored in the memory 100 as described above.

Hereinabove, the system for estimating the impedance spectrum of the battery according to an embodiment of the present invention is described. Hereinafter, a method for estimating the impedance spectrum of the battery cell depending on a processor operation of the impedance spectrum estimation device which is one of the components of the system for estimating the impedance spectrum of the battery will be described in more detail.

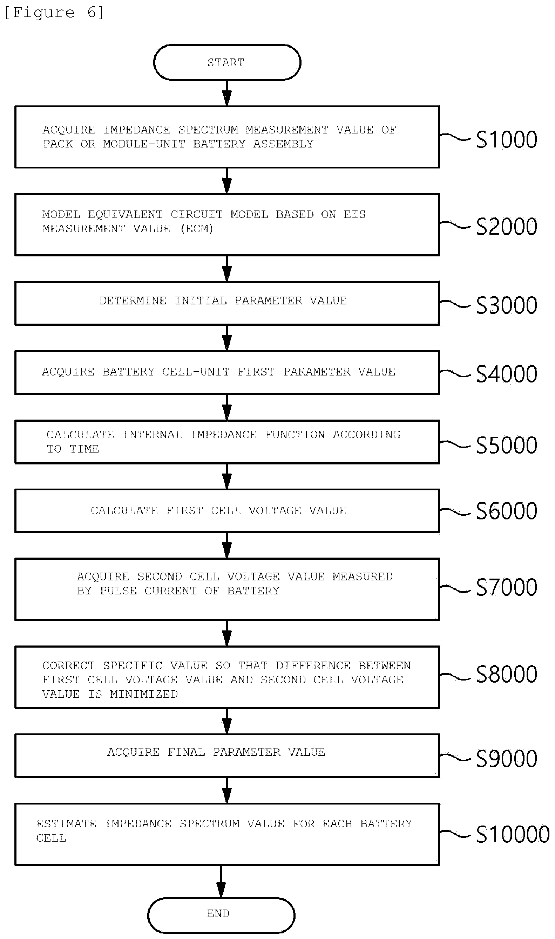

FIG. 6 is a flowchart for describing a method for measuring an impedance spectrum of a battery cell according to an embodiment of the present invention.

Referring to FIG. 6, the processor 200 in the device 5000 for estimating the impedance spectrum of the battery cell may acquire the impedance spectrum measurement value for the pack or module-unit battery assembly (S1000).

According to an embodiment, the processor 200 may receive the impedance spectrum value (EIS measurement value) measured by the pack or module-unit battery assembly from the electrical impedance spectroscopy (EIS) device 1000.

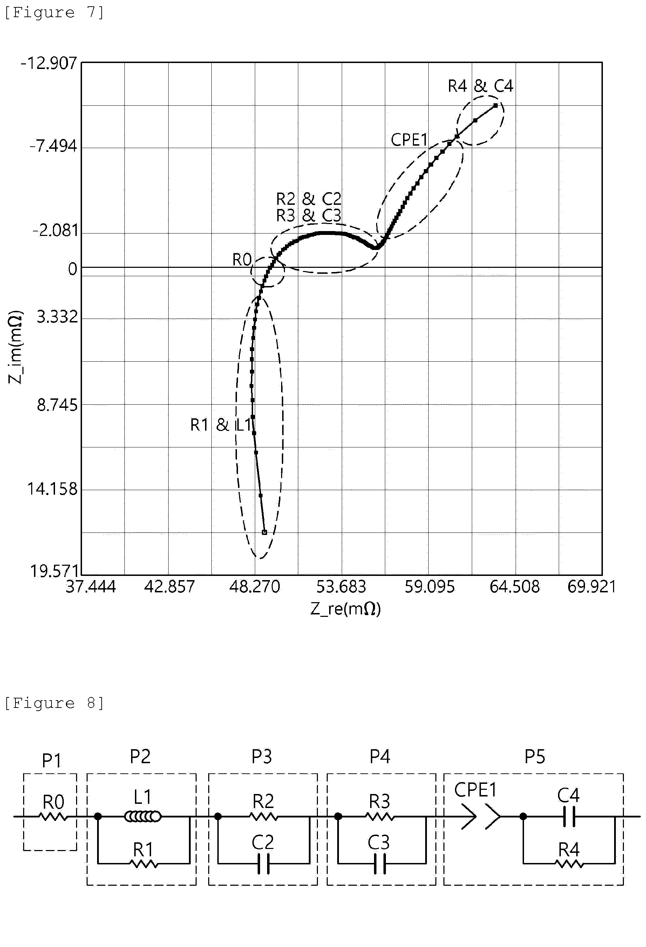

FIG. 7 is a Nyquist Plot graph showing an impedance measurement result for each frequency of a pack or module-unit battery assembly using an electrical impedance spectroscopy (EIS) device according to an embodiment of the present invention.

Referring to FIG. 7, the impedance spectrum measurement value of the battery assembly (pack or module) acquired by the processor 200 may be represented as an impedance output value depending on a frequency. Here, Z' may be a real number value Z_re of the impedance and Z" may be an imaginary number value Z_im of the impedance.

Thereafter, the processor 200 may model the equivalent circuit of the battery assembly which is the pack or module unit (equivalent circuit model (ECM), S2000) based on the acquired EIS measurement value, and determine at least one initial parameter value of the modeled equivalent circuit (S3000). A method for modeling the equivalent circuit of the battery, and determining the initial parameter value of the modeled equivalent circuit will be described in more detail with reference to FIG. 8 below.

FIG. 8 is an equivalent circuit diagram of a battery assembly acquired based on the impedance measurement result in FIG. 7.

Referring to FIG. 8, the processor 200 may model the equivalent circuit of the battery to have the same impedance as the impedance spectrum measurement value of the battery assembly which is the pack or module unit.

According to an embodiment, amplitude and phase components representing output characteristics of the impedance spectrum may be expressed by at least one combination of a resistance, a capacitor, and an inductor. In other words, the pack or module-unit battery equivalent circuit model may be expressed as at least one parameter of resistances R0, R1, R2, R3, and R4, capacitors C1, C2, C3, and C4, an inductor L1, and a Constant Phase Element (CPE). Here, the CPE may be an impedance parameter that makes an intermediate impedance characteristic value of the capacitor and the resistance. For example, the battery equivalent circuit model (ECM) may be expressed as a sum of an impedance P1 depending on an electrolyte, an impedance P2 of the EIS device, an impedance P3 depending on of an SEI layer, an impedance P4 depending on electric charge movement between an electrode and an electrolytic solution interface, and a Warburg impedance coefficient P5. Here, the impedance P2 of the EIS device may include a resistance generated by a cable of a measurement device.

Thereafter, the processor 200 may determine the initial parameter value of the modeled equivalent circuit.

More specifically, the processor 200 may determine the initial parameter value of at least one of the resistance, the capacitor, the inductor, and the CPE in the equivalent circuit model of the battery as in [Table 1] below based on the impedance spectrum measurement value of the battery which is the pack or module unit.

According to an embodiment, the processor 200 may infer values of variables based on the impedance measurement result graph for each frequency in FIG. 7 and the resulting equivalent circuit model in FIG. 8. Thereafter, the processor 200 acquires the impedance measurement result graph for each frequency for the infer values of the variables and compares the acquired impedance measurement result value with the impedance measurement result graph for each frequency according to FIG. 7 to determine values of variables showing a similar pattern to the graph in FIG. 7 as the initial parameter value.

[Table 1]

| ECM Parameter | Initial parameter value |
|---|---|
| R0 | 0.0069 |
| L1 | 4.0044e-07 |
| R1 | 0.26 |
| R2 | 0.00186 |
| C2 | 4.405 |
| R3 | 0.0032 |
| C3 | 32.28 |
| CPE1 | 1362 |
| R4 | 0.033 |
| C4 | 470.5 |

R0: Electrolyte Resistance
L1: Inductance of EIS device (line inductance)
R1: Resistance of the EIS device
R2: Resistance of solid electrolyte interphase (SEI) layer
C2: Capacitance of solid electrolyte interphase (SEI) layer
R3: Charge Transfer Resistance (Rct)
C3: Capacitance in double layers
CPE1, R4, C4: Warburg impedance coefficient

Referring back to FIG. 6, the processor 200 divides the initial parameter value by a conversion constant n_Factor to acquire a battery cell-unit first parameter value as in [Table 2] below (S4000).

Here, the conversion constant n-factor may be a constant for converting the initial parameter value acquired based on the pack or module-unit battery assembly into the batter cell unit. According to an embodiment, an initial value of the conversion factor n-Factor may be defined based on the number of battery cells included in the battery assembly (pack or module). For example, as in [Table 2] below, some initial values R1, R2, and R3 of the conversion constants n-factor may be defined based on the number of battery cells (20 battery cells) included in the module.

Meanwhile, as in [Table 2] below, since the inductor L1 and the capacitors C1, C2, C3, and C4 slightly influence a change of a value of the impedance R (see [Equation 1] below), the conversion constant n-factor may not be defined.

[Table 2]

| ECM Parameter | Initial parameter value | n-Factor | First parameter value |
|---|---|---|---|
| R0 | 0.0069 | 20.745 | 0.0003326 |
| L1 | 4.0044e-07 | - | 4.0044e-07 |
| R1 | 0.26 | 20 | 0.013 |
| R2 | 0.00186 | 20 | 0.000093 |
| C2 | 4.405 | - | 4.405 |
| R3 | 0.0032 | 20 | 0.00016 |
| C3 | 32.28 | - | 32.28 |
| CPE1 | 1362 | 1/7 | 9534 |
| R4 | 0.033 | 2200 | 0.000015 |
| C4 | 470.5 | - | 470.5 |

Further, the conversion constant may be corrected according to a comparison result of the first cell voltage value and the second cell voltage value in step S8000 to be described below. As a result, an initial value of the conversion constant may not be defined as an accurate value. However, as in [Table 2] above, it is preferable that the conversion constant is defined as an approximate value for converting the assembly-unit parameter into the battery cell unit.

In an embodiment, the initial value of the conversion constant may be input by an administrator or defined as a prestored value corresponding to the number of battery cells.

Thereafter, the processor 200 may calculate an internal impedance function according to the time of the battery (S5000).

More specifically, the processor 200 may organize the equivalent circuit (ECM, see FIG 8) of the battery assembly (pack or module) into a function for the time by using a differential equation.

For example, when the method in which the processor 200 organizes RC parallel components P2, P3, and P4 in the equivalent circuit into the function for the time is described in more detail, the processor 200 may organize the RC parallel component into [Equation 1] for current I by using the law of ohm (V = IR).

[Equation 1]

$$I_R(t) = \frac{V_{(t)}}{R}$$

$I_R$: Current applied to resistance

[Equation 2]

$$I_C(t) = C\frac{dV(t)}{d(t)} = I_O - I_R = I_0 - \frac{V(t)}{R}$$

$I_R$: Current applied to resistance
$I_C$: Current applied to capacitance
$I_O$: Discharge current
C: Capacitance

Thereafter, the processor 200 may express V(t) as E(t) based on [Equation 3] extracted from [Equation 2], and organize V(t) into [Equation 4] for E(t).

[Equation 3]

$$C\frac{dV(t)}{d(t)} = I_0 - \frac{V(t)}{R}$$

[Equation 4]

$$E(t) = I_0 R \left( 1 - e^{-\frac{t}{RC}} \right)$$

Thereafter, the processor 200 organizes [Equation 4] into an equation for the impedance R to obtain [Equation 5]

[Equation 5]

$$R(t) = \frac{E(t)}{I(t)} = R\left( 1 - e^{-\frac{t}{RC}} \right)$$

As such, when the processor 200 also organizes an LR parallel component in the equivalent circuit model according to FIG. 8 like the RC parallel component by using the differential equation, the processor 200 may acquire the impedance function for the time from the equivalent circuit model as in [Equation 6] below.

[Equation 6]

$$R(t) = \frac{E(t)}{I(t)} = R_0 + \left( R_1 \cdot e^{-\frac{R_1 t}{L_1}} \right) + \sum_{n=2}^{3} R_n \left( 1 - e^{-\frac{t}{R_n C_n}} \right) + kW_6 t^{\frac{1}{2}} + R_4 \left( 1 - e^{-\frac{t}{R_4 C_4}} \right)$$

R0: Electrolyte Resistance
L1: Line inductance of EIS device
R1: Resistance of EIS device
R2: Resistance of Solid Electrolyte Interphase (SEI) Layer
C2: Capacitance of the SEI layer

R3: Charge Transfer Resistance (Rct)
C3: Capacitance in electrode and electrolytic double layers
CPE1, R4, C4: Warburg impedance coefficient
t: Time
K: Constant
W: Warburg impedance coefficient

Thereafter, the processor 200 may apply the battery cell-unit first parameter value to the impedance function. In this case, $W_6$ as a Warburg impedance may be related to a diffusion speed of ions, and may be in inverse proportion to a square root of the frequency. As a result, the processor 200 may calculate an internal impedance of the cell-unit battery.

Thereafter, the processor 200 may calculate a fist cell voltage value by multiplying the internal impedance of the battery by a current value (S6000). In other words, the internal impedance of the battery may serve as an internal resistance value of the battery.

Further, the processor 200 may acquire a second cell voltage value measured by pulse current of the battery (S7000). Here, the second cell voltage value may be a cell voltage value measured by applying discharge pulse current to the pack or module-unit battery assembly from the battery charging/discharging measurement device 3000.

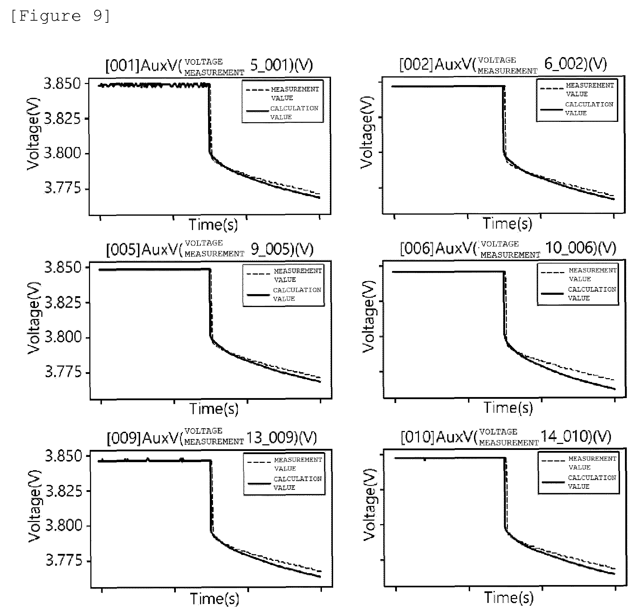

FIG. 9 is a graph of comparing a first cell voltage value calculated by using an impedance function to which a first parameter is applied and a second cell voltage value measured by applying discharge pulse current to a battery assembly in order to describe a method for estimating an impedance of a battery cell according to an experimental example of the present invention.

Referring to FIG. 9, since the first cell voltage value is calculated by using a conversion constant defined based on the number of cells generally accommodated inside the battery assembly (pack or module), as a result of comparing the first cell voltage value and the second cell voltage value, there is a minute difference between the first cell voltage value and a second cell voltage value actually measured by applying the discharge pulse current.

Therefore, the processor 200 may correct the conversion constant n-factor so that the difference between the first cell voltage value and the second cell voltage value is minimized for each cell for calculation of a more precise impedance of the battery cell (S8000).

Here, the conversion constant n-factor may be a value divided to estimate at least one initial parameter constituting the equivalent circuit of the pack or module-unit battery assembly by a cell-unit value as described above. In other words, the processor 200 may acquire a more precise battery cell-unit final parameter value by correcting the conversion constant applied to the initial parameter of the equivalent circuit model by a value to minimize the difference between the first cell voltage value and the second cell voltage value (S9000).

For example, when the battery assembly (pack or module) is constituted by 20 cells, the processor 200 may correct the equivalent circuit parameter value for each battery cell as in [Table 3] below.

[Table 3]

| ECM Parameter | Final parameter value of first cell | Final parameter value of second cell | ... Final parameter value of 200th cell |
|---|---|---|---|
| R0 | 0.000341065 | 0.00036 | 0.000326 |
| L1 | 4.99e-07 | 4.99e-07 | 5.04e-07 |
| R1 | 0.012943 | 0.012943 | 0.013327 |
| R2 | 0.000100021 | 7.6e-05 | 7.00e-05 |
| C2 | 4.322 | 4.322 | 4.73 |
| R3 | 0.000179 | 0.000179 | 0.000138 |
| C3 | 33.92 | 33.92 | 33.43 |
| CPE1 | 9479.115474 | 9425.035 | 9667.56 |
| R4 | 4.27E-06 | 2.50e-05 | 8.77E-05 |
| C4 | 509.1 | 509.1 | 496.5 |

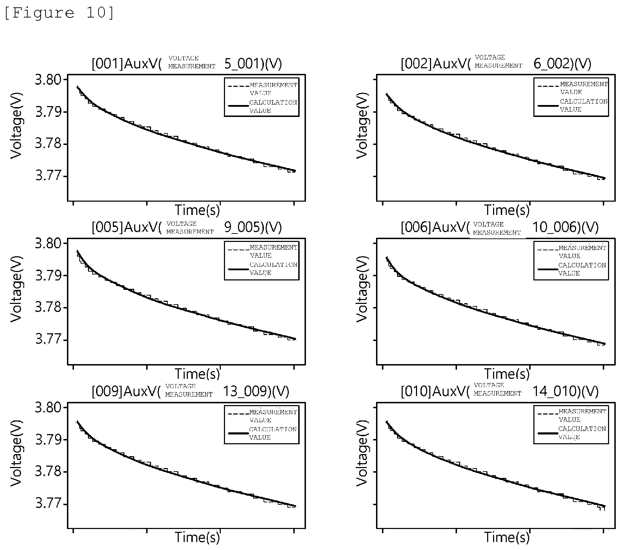

FIG. 10 is a graph of comparing a third cell voltage value calculated by using an equivalent circuit model to which a final parameter value is applied and a second cell voltage value measured by applying discharge pulse current to a battery assembly in order to describe a method for estimating an impedance of a battery cell according to an experimental example of the present invention.

Referring to FIG. 10, a third cell voltage may be a value calculated by multiplying the internal impedance acquired by applying the final parameter to the impedance function by the current value according to an embodiment of the present invention.

According to an embodiment, it may be identified that by a result of comparing the third cell voltage and the second cell voltage value measured by inputting actual discharge pulse current, the third cell voltage value calculated by using the final parameter value acquired by correcting the conversion constant is similar to the second cell voltage value measured by applying the actual discharge pulse current.

Referring back to FIG. 6, the processor 200 individually applies the corrected battery cell-unit final parameter value to the equivalent circuit model to estimate the impedance spectrum for each battery cell (S10000).

According to an embodiment, the processor 200 may acquire the impedance spectrum estimation value for each battery cell by substituting the impedance spectrum measurement value acquired from the pack or module-unit battery assembly into the corrected equivalent circuit model to which the corrected final parameter value is applied. In this case, the corrected final parameter value may also be converted into the impedance spectrum value (Zre and Zim), and used.

Hereinabove, the device and the method for estimating the impedance spectrum of the battery according to the embodiment and the experimental example of the present invention, and the system including the same are described.

According to an embodiment and an experimental example of the present invention, a device and a method for estimating an impedance spectrum of a battery, and a system including the same can a device and a method for estimating an impedance spectrum of a high-efficiency and low-cost battery, and a system including the same, which estimate a cell-unit battery impedance spectrum value by acquiring measurement values from an Electrical Impedance Spectroscopy (EIS) device measuring an impedance spectrum value of a pack or module-unit battery assembly and a battery charging/discharging measurement device measuring a specific parameter value by charging or discharging by applying pulse current to the pack or module-unit battery assembly to facilitate reassembly and reduce cost by enabling non-destruction measurement without disassembling the battery into the cell unit.

The operation of the method according to the embodiment and the experimental example of the present invention may be implemented as a computer readable program or code in a computer readable recording medium. The computer readable recording medium includes all kinds of recording devices storing data which may be deciphered by a computer system. Further, the computer readable recording media may store and execute programs or codes which may be distributed in the computer system connected through a network and read by a computer in a distribution method.

Further, the computer readable recording medium may include a hardware device particularly configured to store and perform a program command, such as a ROM, a RAM, a flash memory, etc. An example of the program command includes a high-level language code executable by a computer by using an interpreter and the like, as well as a machine language code created by a compiler.

Some aspects of the present invention are described in a context of the device, but a description depending on the method corresponding thereto may also be represented, and here, the block or device corresponds to a method step or a feature of the method step. Similarly, the aspects described in the context of the method may also be represented as a feature of a corresponding block or item, or a corresponding device. Some or all of the method steps may be performed by (or using) a hardware device such as a microprocessor, a programmable computer, or an electronic circuit, for example. In some embodiments, at least one of the most important method steps may be performed by such a device.

The present invention has been described with reference to the preferred embodiments of the present invention, but those skilled in the art will understand that the scope of the present invention is defined in the appended claims.

**Claims**

1. A device (5000) for estimating an impedance spectrum of a battery cell, the device comprising:

   a memory (100); and
   a processor (200) performing at least one command stored in the memory,
   wherein the at least one command includes
   a command of instructing acquiring an electrical impedance spectroscopy, EIS, measurement value of a battery assembly,
   a command of instructing modeling an equivalent circuit model (ECM) of the battery assembly, and determining initial parameter values for the equivalent circuit, based on the EIS measurement value,
   a command of instructing deriving a first parameter value by converting at least one of the initial parameter values by using a predefined conversion constant, and calculating a first cell voltage value based on the first parameter value,
   a command of instructing acquiring a second cell voltage value measured by charging or discharging for the battery cell,

a command of instructing comparing the first cell voltage value and the second cell voltage value, and correcting the conversion constant based on a comparison result,
a command of instructing calculating a final parameter value based on the corrected conversion constant, and
a command of instructing acquiring an EIS estimation value for the battery cell by applying the final parameter value to the equivalent circuit.

2. The device for estimating an impedance spectrum of a battery cell of claim 1, wherein the initial parameter value of the equivalent circuit includes a parameter value of at least one of a resistance, a capacitor, an inductor, and a constant phase element (CPE).

3. The device for estimating an impedance spectrum of a battery cell of claim 1, wherein the conversion constant is a constant for converting the equivalent circuit of the battery assembly into the equivalent circuit of the battery cell.

4. The device for estimating an impedance spectrum of a battery cell of claim 1, wherein the command of instructing calculating the first cell voltage value includes

a command of instructing converting the equivalent circuit into an impedance function for a time, and acquiring an internal impedance by applying the initial parameter value to the impedance function, and
a command of instructing calculating the first cell voltage value by multiplying the internal impedance by a current value.

5. The device for estimating an impedance spectrum of a battery cell of claim 4, wherein the impedance function is a function of converting the equivalent circuit into a function for the time by using a predefined differential equation.

6. The device for estimating an impedance spectrum of a battery cell of claim 1, wherein the second cell voltage value is a cell voltage value measured by discharge pulse current of the battery cell.

7. The device for estimating an impedance spectrum of a battery cell of claim 1, wherein the command of instructing correcting the conversion constant includes
a command of instructing correcting the conversion constant so that a difference between the first cell voltage value and the second cell voltage value is minimized.

8. A method for estimating an impedance spectrum of a battery cell, the method comprising:

acquiring an electrical impedance spectroscopy, EIS, measurement value of a battery assembly;
modeling an equivalent circuit model (ECM) of the battery assembly, and determining initial parameter values for the equivalent circuit, based on the EIS measurement value;
deriving a first parameter value by converting at least one of the initial parameter values by using a predefined conversion constant, and calculating a first cell voltage value based on the first parameter value;
acquiring a second cell voltage value measured by charging or discharging for the battery cell;
comparing the first cell voltage value and the second cell voltage value, and correcting the conversion constant based on a comparison result;
calculating a final parameter value based on the corrected conversion constant; and
acquiring an EIS estimation value for the battery cell by applying the final parameter value to the equivalent circuit.

9. The method for estimating an impedance spectrum of a battery cell of claim 8, wherein at least one initial parameter value of the equivalent circuit includes a parameter value of at least one of a resistance, a capacitor, an inductor, and a constant phase element (CPE).

10. The method for estimating an impedance spectrum of a battery cell of claim 8, wherein the conversion constant is a constant for converting the equivalent circuit of the battery assembly into the equivalent circuit of the battery cell.

11. The method for estimating an impedance spectrum of a battery cell of claim 8, wherein the calculating of the first cell voltage value includes

converting the equivalent circuit into an impedance function for a time, and acquiring an internal impedance by applying the initial parameter value to the impedance function, and
calculating the first cell voltage value by multiplying the internal impedance by a current value.

12. The method for estimating an impedance spectrum of a battery cell of claim 11, wherein the impedance function is a function of converting the equivalent circuit into a function for the time by using a predefined differential equation.

13. The method for estimating an impedance spectrum of a battery cell of claim 8, wherein the second cell voltage value is a cell voltage value measured by discharge pulse current of the battery cell.

14. The method for estimating an impedance spectrum of a battery cell of claim 8, wherein the correcting of the conversion constant includes correcting the conversion constant so that a difference between the first cell voltage value and the second cell voltage value is minimized.

15. A system (s) for estimating an impedance spectrum of a battery cell, the system comprising:

an electrical impedance spectroscopy, EIS, device (1000) measuring an impedance spectrum value of a battery assembly;
an impedance estimation device of the battery cell calculating a first cell voltage for the battery cell, and acquiring an EIS estimation value of the battery cell; and
a battery charging/discharging measurement device (3000) measuring a second cell voltage by charging or discharging the battery cell,
wherein the impedance estimation device of the battery cell:

models an equivalent circuit model (ECM) of the battery assembly, and determines at least one of initial parameter values for the equivalent circuit, based on the EIS device measurement value,
derives a first parameter value by converting at least one of the initial parameter values by using a predefined conversion constant, and calculates a first cell voltage value based on the first parameter value,
corrects the conversion constant by comparing the calculated first cell voltage value, and the second cell voltage value measured by the battery charging/discharging measurement device,
calculates a final parameter value based on the corrected conversion constant, and
acquires the EIS estimation value for the battery cell by applying the final parameter value to the equivalent circuit.

**Patentansprüche**

1. Vorrichtung (5000) zum Schätzen eines Impedanzspektrums einer Batteriezelle, wobei die Vorrichtung, umfasst:

einen Speicher (100);
einen Prozessor (200), welcher wenigstens einen in dem Speicher gespeicherten Befehl ausführt,
wobei der wenigstens eine Befehl
einen Befehl eines Anweisens eines Erfassens eines Elektrische-Impedanz-Spektroskopie-, EIS, -Messwerts einer Batterieanordnung,
einen Befehl eines Anweisens eines Modellierens eines Ersatzschaltungsmodells (ECM) der Batterieanordnung und eines Bestimmens initialer Parameterwerte für die Ersatzschaltung auf Grundlage des EIS-Messwerts,
einen Befehl eines Anweisens eines Ableitens eines ersten Parameterwerts durch ein Umwandeln wenigstens eines der initialen Parameterwerte unter Verwendung einer vordefinierten Umwandlungskonstante und eines Berechnens eines ersten Zellenspannungswerts auf Grundlage des ersten Parameterwerts,
einen Befehl eines Anweisens eines Erfassens eines durch ein Laden oder Entladen für die Batteriezelle gemessenen zweiten Zellenspannungswerts,
einen Befehl eines Anweisens eines Vergleichens des ersten Zellenspannungswerts und des zweiten Zellenspannungswerts und eines Korrigierens der Umwandlungskonstante auf Grundlage eines Vergleichsergebnisses,
einen Befehl eines Anweisens eines Berechnens eines finalen Parameterwerts auf Grundlage der korrigierten Umwandlungskonstante und
einen Befehl eines Anweisens eines Erfassens eines EIS-Schätzwerts für die Batteriezelle durch ein Anwenden des finalen Parameterwerts auf die Ersatzschaltung umfasst.

2. Vorrichtung zum Schätzen eines Impedanzspektrums einer Batteriezelle nach Anspruch 1, wobei der initiale Parameterwert der Ersatzschaltung einen Parameterwert wenigstens eines aus einem Widerstand, einem Kondensator, einer Induktivität und einem Element mit konstanter Phase (CPE) umfasst.

3. Vorrichtung zum Schätzen eines Impedanzspektrums einer Batteriezelle nach Anspruch 1, wobei die Umwandlungskonstante eine Konstante zum Umwandeln der Ersatzschaltung der Batterieanordnung in die Ersatzschaltung der Batteriezelle ist.

4. Vorrichtung zum Schätzen eines Impedanzspektrums einer Batteriezelle nach Anspruch 1, wobei der Befehl eines Anweisens eines Berechnens des ersten Zellenspannungswerts

   einen Befehl eines Anweisens eines Umwandelns der Ersatzschaltung in eine Impedanzfunktion für eine Zeit und eines Erfassens einer internen Impedanz durch ein Anwenden des initialen Parameterwerts auf die Impedanzfunktion und
   einen Befehl eines Anweisens eines Berechnens des ersten Zellenspannungswerts durch ein Multiplizieren der internen Impedanz mit einem Stromwert umfasst.

5. Vorrichtung zum Schätzen eines Impedanzspektrums einer Batteriezelle nach Anspruch 4, wobei die Impedanzfunktion eine Funktion eines Umwandelns der Ersatzschaltung in eine Funktion für die Zeit unter Verwendung einer vordefinierten Differentialgleichung ist.

6. Vorrichtung zum Schätzen eines Impedanzspektrums einer Batteriezelle nach Anspruch 1, wobei der zweite Zellenspannungswert ein durch einen Entladeimpulsstrom der Batteriezelle gemessener Zellenspannungswert ist.

7. Vorrichtung zum Schätzen eines Impedanzspektrums einer Batteriezelle nach Anspruch 1, wobei der Befehl eines Anweisens eines Korrigierens der Umwandlungskonstante
   einen Befehl eines Anweisens eines Korrigierens der Umwandlungskonstante umfasst, so dass eine Differenz zwischen dem ersten Zellenspannungswert und dem zweiten Zellenspannungswert minimiert wird.

8. Verfahren zum Schätzen eines Impedanzspektrums einer Batteriezelle, wobei das Verfahren umfasst:

   Erfassen eines Elektrische-Impedanz-Spektroskopie-, EIS, -Messwerts einer Batterieanordnung,
   Modellieren eines Ersatzschaltungsmodells (ECM) der Batterieanordnung und Bestimmen initialer Parameterwerte für die Ersatzschaltung auf Grundlage des EIS-Messwerts;
   Ableiten eines ersten Parameterwerts durch ein Umwandeln wenigstens eines der initialen Parameterwerte unter Verwendung einer vordefinierten Umwandlungskonstante und Berechnen eines ersten Zellenspannungswerts auf Grundlage des ersten Parameterwerts;
   Erfassen eines durch ein Laden oder Entladen für die Batteriezelle gemessenen zweiten Zellenspannungswerts;
   Vergleichen des ersten Zellenspannungswerts und des zweiten Zellenspannungswerts und Korrigieren der Umwandlungskonstante auf Grundlage eines Vergleichsergebnisses;
   Berechnen eines finalen Parameterwerts auf Grundlage der korrigierten Umwandlungskonstante; und
   Erfassen eines EIS-Schätzwerts für die Batteriezelle durch ein Anwenden des finalen Parameterwerts auf die Ersatzschaltung.

9. Verfahren zum Schätzen eines Impedanzspektrums einer Batteriezelle nach Anspruch 8, wobei wenigstens ein initialer Parameterwert der Ersatzschaltung einen Parameterwert wenigstens eines aus einem Widerstand, einem Kondensator, einer Induktivität und einem Element mit konstanter Phase (CPE) umfasst.

10. Verfahren zum Schätzen eines Impedanzspektrums einer Batteriezelle nach Anspruch 8, wobei die Umwandlungskonstante eine Konstante zum Umwandeln der Ersatzschaltung der Batterieanordnung in die Ersatzschaltung der Batteriezelle ist.

11. Verfahren zum Schätzen eines Impedanzspektrums einer Batteriezelle nach Anspruch 8, wobei das Berechnen des ersten Zellenspannungswerts

   ein Umwandeln der Ersatzschaltung in eine Impedanzfunktion für eine Zeit und ein Erfassen einer internen Impedanz durch ein Anwenden des initialen Parameterwerts auf die Impedanzfunktion und
   ein Berechnen des ersten Zellenspannungswerts durch ein Multiplizieren der internen Impedanz mit einem Stromwert umfasst.

12. Verfahren zum Schätzen eines Impedanzspektrums einer Batteriezelle nach Anspruch 11, wobei die Impedanzfunktion eine Funktion eines Umwandelns der Ersatzschaltung in eine Funktion für die Zeit unter Verwendung einer vordefinierten Differentialgleichung ist.

**13.** Verfahren zum Schätzen eines Impedanzspektrums einer Batteriezelle nach Anspruch 8, wobei der zweite Zellenspannungswert ein durch einen Entladeimpulsstrom der Batteriezelle gemessener Zellenspannungswert ist.

**14.** Verfahren zum Schätzen eines Impedanzspektrums einer Batteriezelle nach Anspruch 8, wobei das Korrigieren der Umwandlungskonstante ein Korrigieren der Umwandlungskonstante umfasst, so dass eine Differenz zwischen dem ersten Zellenspannungswert und dem zweiten Zellenspannungswert minimiert wird.

**15.** System zum Schätzen eines Impedanzspektrums einer Batteriezelle, wobei das System umfasst:

eine Elektrische-Impedanz-Spektroskopie-, EIS, -Vorrichtung (1000), welche einen Impedanzspektrumswert einer Batterieanordnung misst;
eine Impedanzschätzvorrichtung der Batteriezelle, welche eine erste Zellenspannung für die Batteriezelle berechnet und einen EIS-Schätzwert der Batteriezelle erfasst; und
eine Batterie-Lade-/Entlademessvorrichtung (3000), welche durch ein Laden oder ein Entladen der Batteriezelle eine zweite Zellenspannung misst,
wobei die Impedanzschätzvorrichtung der Batteriezelle:

ein Ersatzschaltungsmodell (ECM) der Batterieanordnung modelliert und auf Grundlage des EIS-Vorrichtungsmesswerts wenigstens einen von initialen Parameterwerten für die Ersatzschaltung bestimmt,
durch ein Umwandeln wenigstens eines der initialen Parameterwerte unter Verwendung einer vordefinierten Umwandlungskonstante einen ersten Parameterwert ableitet und auf Grundlage des ersten Parameterwerts einen ersten Zellenspannungswert berechnet,
durch ein Vergleichen des berechneten ersten Zellenspannungswerts und des durch die Batterie-Lade-/Entlademessvorrichtung gemessenen zweiten Zellenspannungswerts die Umwandlungskonstante korrigiert,
auf Grundlage der korrigierten Umwandlungskonstante einen finalen Parameterwert berechnet und
durch ein Anwenden des finalen Parameterwerts auf die Ersatzschaltung den EIS-Schätzwert für die Batteriezelle erfasst.

**Revendications**

**1.** Dispositif (5000) d'estimation d'un spectre d'impédance d'une cellule de batterie, le dispositif comprenant :

une mémoire (100) ; et
un processeur (200) exécutant au moins une commande stockée dans la mémoire,
dans lequel ladite au moins une commande comporte :

une commande d'instruction d'acquisition d'une spectroscopie d'impédance électrique, EIS, valeur de mesure d'un ensemble batterie,
une commande d'instruction de modélisation d'un modèle de circuit équivalent (ECM) de l'ensemble batterie, et de détermination de valeurs de paramètres initiales pour le circuit équivalent, sur la base de la valeur de mesure EIS,
une commande d'instruction de dérivation d'une première valeur de paramètre en convertissant au moins l'une des valeurs de paramètre initiales à l'aide d'une constante de conversion prédéfinie, et de calcul d'une première valeur de tension de cellule sur la base de la première valeur de paramètre,
une commande d'instruction d'acquisition d'une seconde valeur de tension de cellule mesurée par charge ou décharge pour la cellule de batterie,
une commande d'instruction de comparaison de la première valeur de tension de cellule et de la seconde valeur de tension de cellule, et de correction de la constante de conversion sur la base d'un résultat de comparaison,
une commande d'instruction de calcul d'une valeur de paramètre finale sur la base de la constante de conversion corrigée, et
une commande d'instruction d'acquisition d'une valeur d'estimation EIS pour la cellule de batterie en appliquant la valeur de paramètre finale au circuit équivalent.

**2.** Dispositif d'estimation d'un spectre d'impédance d'une cellule de batterie selon la revendication 1, dans lequel la valeur de paramètre initiale du circuit équivalent comporte une valeur de paramètre d'au moins l'un parmi une résistance, un condensateur, un inducteur et un élément de phase constante (CPE).

3. Dispositif d'estimation d'un spectre d'impédance d'une cellule de batterie selon la revendication 1, dans lequel la constante de conversion est une constante pour convertir le circuit équivalent de l'ensemble batterie en le circuit équivalent de la cellule de batterie.

4. Dispositif d'estimation d'un spectre d'impédance d'une cellule de batterie selon la revendication 1, dans lequel la commande d'instruction de calcul de la première valeur de tension de cellule comporte

une commande d'instruction de conversion du circuit équivalent en une fonction d'impédance pendant un certain temps, et d'acquisition d'une impédance interne en appliquant la valeur de paramètre initiale à la fonction d'impédance, et
une commande d'instruction de calcul de la première valeur de tension de cellule en multipliant l'impédance interne par une valeur de courant.

5. Dispositif d'estimation d'un spectre d'impédance d'une cellule de batterie selon la revendication 4, dans lequel la fonction d'impédance est une fonction de conversion du circuit équivalent en une fonction pendant un certain temps à l'aide d'une équation différentielle prédéfinie.

6. Dispositif d'estimation d'un spectre d'impédance d'une cellule de batterie selon la revendication 1, dans lequel la seconde valeur de tension de cellule est une valeur de tension de cellule mesurée par le courant d'impulsion de décharge de la cellule de batterie.

7. Dispositif d'estimation d'un spectre d'impédance d'une cellule de batterie selon la revendication 1, dans lequel la commande d'instruction de correction de la constante de conversion comporte
une commande d'instruction de correction de la constante de conversion de sorte qu'une différence entre la première valeur de tension de cellule et la seconde valeur de tension de cellule soit minimisée.

8. Procédé d'estimation d'un spectre d'impédance d'une cellule de batterie, le procédé comprenant :

l'acquisition d'une spectroscopie d'impédance électrique, EIS, valeur de mesure d'un ensemble batterie ;
la modélisation d'un modèle de circuit équivalent (ECM) de l'ensemble batterie, et la détermination de valeurs de paramètres initiales pour le circuit équivalent, sur la base de la valeur de mesure EIS ;
la dérivation d'une première valeur de paramètre en convertissant au moins l'une des valeurs de paramètre initiales à l'aide d'une constante de conversion prédéfinie, et le calcul d'une première valeur de tension de cellule sur la base de la première valeur de paramètre ;
l'acquisition d'une seconde valeur de tension de cellule mesurée par charge ou décharge pour la cellule de batterie ;
la comparaison de la première valeur de tension de cellule et de la seconde valeur de tension de cellule, et la correction de la constante de conversion sur la base d'un résultat de comparaison ;
le calcul d'une valeur de paramètre finale sur la base de la constante de conversion corrigée ; et
l'acquisition d'une valeur d'estimation EIS pour la cellule de batterie en appliquant la valeur de paramètre finale au circuit équivalent.

9. Procédé d'estimation d'un spectre d'impédance d'une cellule de batterie selon la revendication 8, dans lequel au moins une valeur de paramètre initiale du circuit équivalent comporte une valeur de paramètre d'au moins l'un parmi une résistance, un condensateur, un inducteur et un élément de phase constante (CPE).

10. Procédé d'estimation d'un spectre d'impédance d'une cellule de batterie selon la revendication 8, dans lequel la constante de conversion est une constante pour convertir le circuit équivalent de l'ensemble batterie en circuit équivalent de la cellule de batterie.

11. Procédé d'estimation d'un spectre d'impédance d'une cellule de batterie selon la revendication 8, dans lequel le calcul de la première valeur de tension de cellule comporte

la conversion du circuit équivalent en une fonction d'impédance pendant un certain temps, et l'acquisition d'une impédance interne en appliquant la valeur de paramètre initiale à la fonction d'impédance, et

le calcul de la première valeur de tension de cellule en multipliant l'impédance interne par une valeur de courant.

12. Procédé d'estimation d'un spectre d'impédance d'une cellule de batterie selon la revendication 11, dans lequel la fonction d'impédance est une fonction de conversion du circuit équivalent en une fonction pendant un certain temps à l'aide d'une équation différentielle prédéfinie.

13. Procédé d'estimation d'un spectre d'impédance d'une cellule de batterie selon la revendication 8, dans lequel la seconde valeur de tension de cellule est une valeur de tension de cellule mesurée par le courant d'impulsion de décharge de la cellule de batterie.

14. Procédé d'estimation d'un spectre d'impédance d'une cellule de batterie selon la revendication 8, dans lequel la correction de la constante de conversion comporte la correction de la constante de conversion de sorte qu'une différence entre la première valeur de tension de cellule et la seconde valeur de tension de cellule soit minimisée.

15. Système (S) d'estimation d'un spectre d'impédance d'une cellule de batterie, le système comprenant :

un dispositif de spectroscopie d'impédance électrique, EIS, (1000) mesurant une valeur de spectre d'impédance d'un ensemble batterie ;
un dispositif d'estimation d'impédance de la cellule de batterie calculant une première tension de cellule pour la cellule de batterie, et acquérant une valeur d'estimation EIS de la cellule de batterie ; et
un dispositif de mesure de charge/décharge de batterie (3000) mesurant une seconde tension de cellule par charge ou décharge de la cellule de batterie,
dans lequel le dispositif d'estimation d'impédance de la cellule de batterie :

modélise un modèle de circuit équivalent (ECM) de l'ensemble batterie, et détermine au moins une des valeurs de paramètre initiales pour le circuit équivalent, sur la base de la valeur de mesure du dispositif EIS, dérive une première valeur de paramètre en convertissant au moins l'une des valeurs de paramètre initiales à l'aide d'une constante de conversion prédéfinie, et calcule une première valeur de tension de cellule sur la base de la première valeur de paramètre,
corrige la constante de conversion en comparant la première valeur de tension de cellule calculée, et la seconde valeur de tension de cellule mesurée par le dispositif de mesure de charge/décharge de batterie, calcule une valeur de paramètre finale sur la base de la constante de conversion corrigée, et
acquiert la valeur d'estimation EIS pour la cellule de batterie en appliquant la valeur de paramètre finale au circuit équivalent.

[Figure 1]

[Figure 2]

S

```
IMPEDANCE SPECTRUM
ESTIMATION APPARATUS OF      5000
BATTERY CELL
```

1000                                          3000

```
ELECTRICAL IMPEDANCE        BATTERY PACK
SPECTROSCOPY (EIS)          CHARGING/DISCHARGING
DEVICE                      MEASUREMENT
                            DEVICE
```

[Figure 3]

[Figure 4]

[Figure 5]

[Figure 6]

```
                           ┌─────────┐
                           │  START  │
                           └────┬────┘
                                │
                                ▼
   ┌──────────────────────────────────────────────────┐
   │ ACQUIRE IMPEDANCE SPECTRUM MEASUREMENT VALUE OF   │ ─── S1000
   │ PACK OR MODULE-UNIT BATTERY ASSEMBLY              │
   └──────────────────────────┬───────────────────────┘
                              ▼
   ┌──────────────────────────────────────────────────┐
   │ MODEL EQUIVALENT CIRCUIT MODEL BASED ON EIS       │ ─── S2000
   │ MEASUREMENT VALUE (ECM)                           │
   └──────────────────────────┬───────────────────────┘
                              ▼
   ┌──────────────────────────────────────────────────┐
   │ DETERMINE INITIAL PARAMETER VALUE                 │ ─── S3000
   └──────────────────────────┬───────────────────────┘
                              ▼
   ┌──────────────────────────────────────────────────┐
   │ ACQUIRE BATTERY CELL-UNIT FIRST PARAMETER VALUE   │ ─── S4000
   └──────────────────────────┬───────────────────────┘
                              ▼
   ┌──────────────────────────────────────────────────┐
   │ CALCULATE INTERNAL IMPEDANCE FUNCTION ACCORDING   │ ─── S5000
   │ TO TIME                                           │
   └──────────────────────────┬───────────────────────┘
                              ▼
   ┌──────────────────────────────────────────────────┐
   │ CALCULATE FIRST CELL VOLTAGE VALUE                │ ─── S6000
   └──────────────────────────┬───────────────────────┘
                              ▼
   ┌──────────────────────────────────────────────────┐
   │ ACQUIRE SECOND CELL VOLTAGE VALUE MEASURED        │ ─── S7000
   │ BY PULSE CURRENT OF BATTERY                       │
   └──────────────────────────┬───────────────────────┘
                              ▼
   ┌──────────────────────────────────────────────────┐
   │ CORRECT SPECIFIC VALUE SO THAT DIFFERENCE BETWEEN │ ─── S8000
   │ FIRST CELL VOLTAGE VALUE AND SECOND CELL VOLTAGE  │
   │ VALUE IS MINIMIZED                                │
   └──────────────────────────┬───────────────────────┘
                              ▼
   ┌──────────────────────────────────────────────────┐
   │ ACQUIRE FINAL PARAMETER VALUE                     │ ─── S9000
   └──────────────────────────┬───────────────────────┘
                              ▼
   ┌──────────────────────────────────────────────────┐
   │ ESTIMATE IMPEDANCE SPECTRUM VALUE FOR EACH BATTERY│ ─── S10000
   │ CELL                                              │
   └──────────────────────────┬───────────────────────┘
                              ▼
                           ┌─────────┐
                           │   END   │
                           └─────────┘
```

[Figure 7]

[Figure 8]

[Figure 9]

[Figure 10]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210149820
- KR 1020220145075
- EP 3876334 A1